# EUROPÄISCHE PATENTANMELDUNG

(11) **EP 1 447 656 A1**
(43) Veröffentlichungstag der Anmeldung: **18.08.2004**
(21) Anmeldenummer: 03029595.0
(22) Anmeldetag: 23.12.2003
(51) Int. Cl.: G01N 1/32, H01J 37/305

(54) **Proben für die Transmissions-Elektronen-Mikroskopie**

(30) Priorität: 15.02.2003 CH 2252003
(71) Anmelder: BAL-TEC AG, 9496 Balzers (LI)
(72) Erfinder: Wofgang, Grünewald, 09122 Chemnitz (DE)
(74) Vertreter: Wegmann, Urs

(57) **Zusammenfassung**

TEM-FIB-Proben aus einem Festkörpermaterial werden durch einen Nachbehandlungsschritt kontaminationsfrei und zerstörungsfrei auf sehr geringe Dicken nachgedünnt durch wechselseitiges Beschiessen der Probenoberflächen (6a, b) mit einem Ionenstrahl (8), womit eine hochauflösende Betrachtung und Analyse des Probenmaterials (5) mit einem TEM ermöglicht wird.

## Beschreibung

Die Erfindung bezieht sich auf eine TEM-FIB-Probe gemäss Oberbegriff nach Anspruch 1 sowie auf ein Verfahren zur Herstellung einer solchen Probe gemäss Oberbegriff nach Anspruch 7.

Proben wird für die Transmissions-Elektronen-Mikroskopie (TEM) können auf verschiedene Art präpariert werden. Um Proben mit einem TEM betrachten zu können, müssen diese entsprechend definiert gedünnt werden, so dass diese im TEM durchstrahlt werden können. Hierbei ist die Qualität der Bildauflösung ganz wesentlich von der Qualität der Probe abhängig. Dafür sollte die Probe auf eine entsprechend gewünschte, definierte Dicke gleichförmig eingestellt werden durch einen entsprechenden Ätzvorgang. Hierbei ist es wichtig, dass bei diesem Ätzvorgang die Probenstruktur nicht durch den Vorgang selbst verändert wird. Dies führt allerdings nicht zu der gewünschten Qualität der Probe entsprechend den heutigen Anforderungen. Die nasschemische Ätzmethode ist diesbezüglich nicht ziehlführend.
Aus diesem Grunde werden für die hochqualitativen TEM-Proben heute die Proben mit einem fixierten Argon-Ionen-Strahl, der etwa einen Durchmesser von ca. 1 mm aufweist, durch Ätzen bearbeitet. Eine weitere bekannte und heute bevorzugte Methode besteht darin, mit einem fokussierten Ionenstrahl (FIB-Technik) die Probe herauszuarbeiten und wunschgemäss zu dünnen. Hierbei wird ein gerasterter, fein fokussierter Gallium-Ionen-Strahl mit einem Strahldurchmesser von wenigen nm eingesetzt, mit dessen Hilfe TEM-Proben lamellenförmig, durch senkrechten Beschuss der Oberfläche, aus dem Festmaterial herauspräpariert werden können. Typischerweise sind hierbei die Probenlamellen etwa 80 bis 100 nm dick. Diese neueste FIB-Präparations-Technik ist beispielsweise beschrieben in P. Gnauck, P. Hoffrogge, ICEM 15, Durban, (Supply 1: Proceedings), (2002) 3,32.

Die Technik zur Herstellung von FIB-Proben für TEM-Lamellen weist allerdings verschiedene Nachteile auf. Die Lamelle kann nicht so dünn präpariert werden, dass die Proben für die hochauflösende Transmissions-Elektronen-Mikroskopie (HRTEM) gut geeignet wäre. Die TEM-Lamelle wird ausserdem durch die Präparation kontaminiert und weist im Vergleich zur konventionellen Ionenstral-Präparation, mit fixiertem Jonenstrahl, wesentlich höhere Randamorphisierungen auf. Diese Randamorphisierung ist eine Störung der ursprünglichen Struktur in der Oberfläche der Probe und zwar auf beiden Seiten der Probe und dies bis in Tiefen von etwa 20 nm auf beiden Seiten der Probe. Bei konventioneller Probenherstellung mittels fixiertem Ionenstrahl-Ätzen reicht diese Zerstörung der ursprünglichen Struktur nur etwa bis 5 nm Tiefe, wobei allerdings die Vorteile, wie beispielsweise die Zielgenauigkeit, der gerasterten FIB-Technik nicht erzielt werden können.

Die vorerwähnten Probleme führen zu einer stark verminderten Probenqualität. Um diese Probleme lösen zu können, wurden in letzter Zeit Versuche unternommen, die FIB-Proben mit Hilfe der konventionellen nichtgerasterten Ionenstrahl-Präparation nachzudünnen. Aufgrund der Probengeometrie und der einseitigen Ätzung der Lamelle kommt es aber zu zusätzlichen, unerwünschten Kontaminationen. Solche Kontaminationen machen den Vorteil der Nachbehandlung zunichte und die Probe unbrauchbar. Die Problematik der Nachbearbeitung von FIB-Proben ist im Stand der Technik beschrieben bei Max V. Siderov, Microsc. Microanal.8 (Suppl 2: Proceedings), (2002) 560 CD.

Der Erfindung liegt die Aufgabe zugrunde, die Nachteile des Standes der Technik zu beseitigen, insbesondere aber TEM-Proben zu realisieren, welche eine hohe Qualität ermöglichen, insbesondere aber eine hohe Auflösung und Detailwiedergabe bei Betrachtung mit dem TEM ermöglichen.

Die Aufgabe wird erfindungsgemäss durch die Vorrichtung nach Anspruch 1 gelöst und durch Vorgehen nach dem Verfahren nach Anspruch 7. Die abhängigen Ansprüche definieren weitere vorteilhafte Ausführungsformen und Verfahrensschritte.

Die erfindungsgemässe Ausbildung einer Probe, insbesondere einer Probenlamelle, ermöglicht die Herstellung einer genügend dünnen Lamelle, welche bei der TEM-Betrachtung einen hohen Detaillierungsgrad des ursprünglichen Probenmateriales auflösen und abbilden kann. Hierzu wird erfindungsgemäss eine mit der FIB-Technik hergestellte Grobprobe mit einem Ionenstrahl nachbearbeitet und auf die erforderliche Dicke gedünnt beziehungsweise geätzt. Die Nachbearbeitung der Probe muss hierbei kontaminationsfrei sein, das heisst es darf kein Fremdmaterial, wie Umgebungsmaterial oder vom ursprünglichen Material während des Ätzvorganges wieder auf der Probe deponiert werden. Ein weiterer wichtiger Aspekt besteht darin, dass bei dieser Nachbearbeitung die Materialstruktur der Probe an der Oberfläche nicht verändert wird, beziehungsweise die ursprüngliche Struktur des Probenmateriales erhalten bleibt. Da die FIB-Probe als Ausgangsprobe bereits an den Oberflächen Strukturstörungen wie Randamorphisierungen aufweist, die inhärent sind mit der FIB-Technik und etwa 20 nm tief in jede Probenseite hineinreichen, ist es notwendig, dass die Nachbearbeitungstechnik solche Störungsbereiche zu einem wesentlichen Teil eliminieren kann, um das ursprüngliche nicht beeinflusste Material, welches analysiert werden soll, freizulegen. Erfindungsgemäss wird dies dadurch erreicht, indem die Probe durch einen Ionenstrahl unter einem Beschusswinkel wechselseitig auf beiden Seiten beschossen und abgetragen wird. Dadurch ist es möglich, Kontaminationen weitestgehend zu vermeiden, welche für die hochauflösende Transmissions-Elektronen-Mikroskopie (HRTEM) zwingend notwendig ist. Das erfindungsgemässe Verfahren erlaubt nun auch die für diese hochauflösende Technologie benötigten und geeignet dünnen Proben herzustellen von weniger als 40 nm Dicke, ja sogar vorzugsweise von weniger als 20 nm Dicke. Ein weiterer Vorteil besteht darin, dass die erfindungsgemässe Nachbearbeitung für alle FIB-Probenarten anwendbar ist und nicht von der Probengeometrie abhängig ist. Es können also auch komplizierte Probengeometrien nachgearbeitet werden.
Um Vorzugsrichtungen der Jonenstrahlätzung, also unerwünschte riefen artige Strukturen, an der Probenoberfläche zu vermeiden ist es vorteilhaft die Probe gegenüber dem Jonenstrahl zusätzlich zu bewegen. Solche Bewegungen können oszillierend sein und als periodische Kippbewegung der Probe gegenüber der Jonenstrahleinfallsrichtung ausgeführt werden. Diese Bewegung sollte relativ langsam und gleichmässig sein. Die Verkippung kann hierbei vorteilhaft bis um einen Winkel von +- 70 Grad gegenüber der Jonenstrahlrichtung erfolgen und die Bewegungsfrequenz etwa im Bereich von 0,1 Hz.

Die Erfindung wird nun nachfolgend beispielsweise und anhand von schematischen Zeichnungen näher erläutert. Es zeigen:
- Fig. 1: einen mechanische Präparationsschritt zur Herstellung einer FIB - Probe gemäss Stand der Technik
- Fig. 2: eine Halterung und die FIB - Bearbeitung des Präparates gemäss Fig. 1 nach Stand der Technik
- Fig. 3: eine dreidimensionale Darstellung einer fertigen FIB - Probe in einer REM - Aufnahme gemäss Stand der Technik

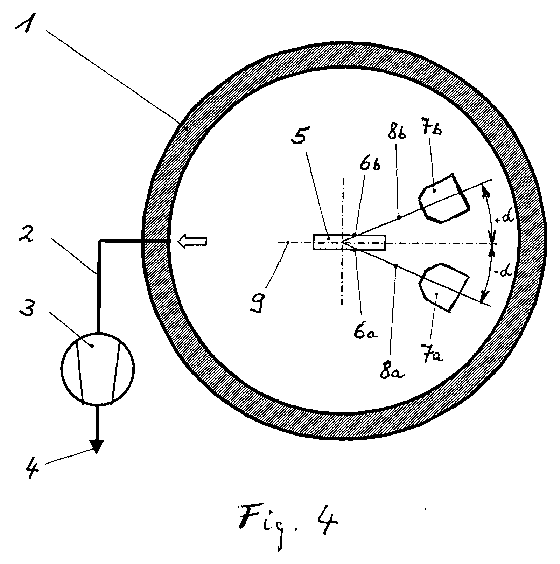

- Fig. 4: eine Anordnung zur erfindungsgemässen Nachbehandlung einer FIB - Probe

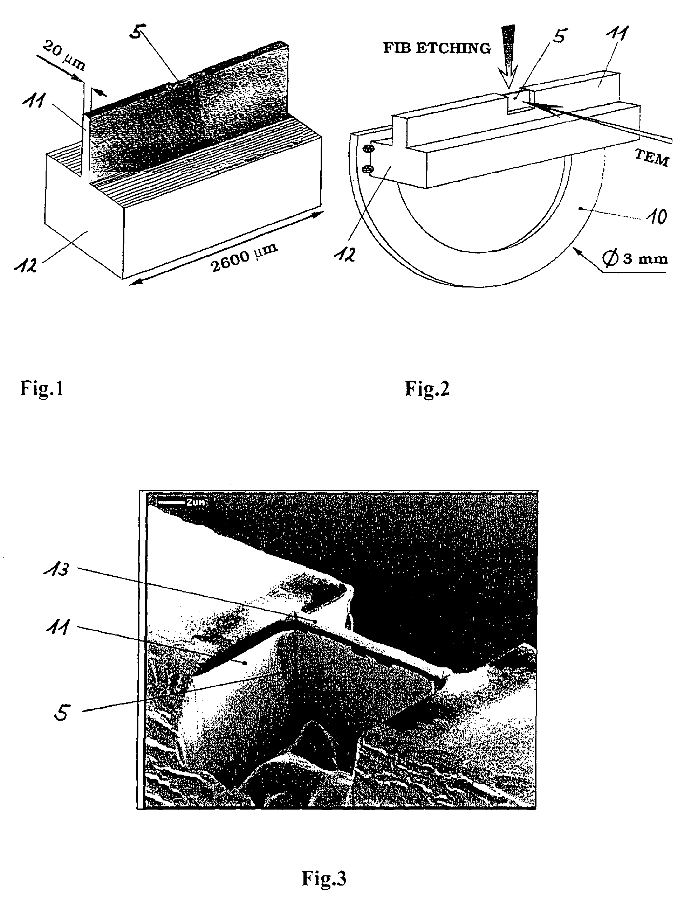

Zur Herstellung einer FIB-Probe wird aus dem Festkörpermaterial, beispielsweise aus einem Halbleiterwafer, ein Probenstück 12 entnommen und an diesem durch mechanisches Sägen ein Steg 11 herausgearbeitet, wie dies beispielsweise in Fig. 1 dargestellt ist. Hierbei ist beispielsweise das Probenstück 12 etwa 2600 µm lang und die Stegbreite etwa 20 µm. Auf der Stirnseite des Steges 11 wird in einem Teilbereich, wo die Lamellenprobe 5 erzeugt werden soll, eine Schutzbeschichtung aufgebracht, welche als Maskierung dient für die darunter liegende und herauszuätzende Lamelle 5. Mit einem senkrecht stirnseitig auf den Steg auftreffenden Focussed-Ion-Beam (FIB) wird nunmehr die Lamelle 5 durch Tiefenätzen frei gelegt. In Fig. 2 ist dies schematisch gezeigt durch die Pfeilangabe mit der Beschriftung "FIB-etching".
Das Probenstück 12 mit der Lamellenprobe 5 wird nun auf einem Probenhalter 10 mit einem Durchmesser von beispielsweise 3 mm angeordnet und kann nun im TEM betrachtet werden, wie dies ebenfalls schematisch in Fig. 2 mit dem Pfeil und der dazugehörigen Beschriftung "TEM" angedeutet ist.
In Fig. 3 ist eine Raster - elektronenmikroskopische (REM) Bildwiedergabe einer solchen Probe 5 gezeigt zur besseren Veranschaulichung. Daraus ist auch ersichtlich, dass die FIB geätzte Lamellen artige Probe (FIB-etching) relativ dick ist. Im Tiefenbereich der Probe sieht man eine hohe Welligkeit des Materiales, welches auch zeigt, dass bei dem Ätz- respektive Zerstäubungsvorgang Kontaminationen auftreten durch Wiederbelegung der beteiligten Oberflächen 6a,b. Der gerasterte FIB-Ionenstrahl muss mit Energien zwischen 5 keV bis 30 keV wegen der notwendigen Fokussierung betrieben werden. Dies führt zu entsprechenden Schäden beziehungsweise Störungen der Materialstruktur beidseitig der Lamellenoberflächen 6a und 6b der Probe 5, typischerweise bis Tiefen von etwa 20 nm.

Erfindungsgemäss wird nunmehr eine FIB-Probe, die bereits eine entsprechenden Lamellenstruktur 5 aufweist, in einem Vakuumrezipienten 1 angeordnet in ihrer Probenanordnungsachse beziehungsweise -ebene 9, um dort entsprechend nachbehandelt zu werden. Der Rezipient 1 wird auf bekannte Weise über eine Abpumpleitung 2 mit einer Vakuumpumpe 3, beispielsweise einer Turbo-Vakuumpumpe, mit Pumpauslass 4 evakuiert. In der Vakuumkammer 1 ist ausserdem eine Ionenquelle 7 angeordnet, welche schräg unter einem Winkel α gegenüber der Probenanordnungsebene 9 mit ihrem Ionenstrahl 8 auf die Probenoberflächen 6a und 6b gerichtet werden kann. Die Probe 5 kann mit der Ionenquelle 7 durch den Ionenbeschuss beidseitig an ihren Oberflächen 6a und 6b geätzt werden und somit auf das gewünschte Mass gedünnt werden. Erfindungsgemäss soll der Ionenstrahl 8 abwechslungsweise 8a,b sowohl auf die eine Seite 6a wie auch auf die andere Seite 6b der Probe 5 gerichtet werden. Durch dieses wechselseitige Ätzen der beiden Probenseiten 6a,b kann eine Wiederbelegung und somit eine Kontamination der Oberflächen 6a,b vermieden werden. Das wechselseitige Ätzen der Oberflächen 6a und 6b erfolgt vorteilhafterweise durch ein periodisches Wechseln der Seiten der Probe 5. Dies kann sowohl durch hin- und herbewegen 7a,b der Ionenquelle 7 um die Probenanordnungsachse 9 erfolgen, wie auch um entsprechende Kippbewegungen der Probe 5 selbst bei stehender Ionenquelle 7. Massgeblich ist hierbei das wechselseitige Ätzen der Probenoberflächen 6a und 6b, welches mit einer Relativbewegung zwischen der Richtung des Ionenstrahles 8 und der Oberflächen 6a und 6b der Probe 5 erzielt werden kann. Der Ionenstrahl 8 mit seinen Positionen 8a und 8b soll hierbei schräg auf die Probenoberflächen 6a und 6b auftreffen entsprechend dem dargestellten Beschusswinkel +α und -α gegenüber der Probenanordnungsebene 9. Die wechselseitige Behandlung der Probenoberflächen 6a und 6b werden vorteilhafterweise durch pendelartige Relativbewegung um den Winkelbereich +α/-α ausgeführt. Hierbei durchläuft der Ionenstrahl auch den Nullgrad-Winkel, welcher mit der Probenanordnungsebene 9 zusammen fällt. Kontaminationen der Probe 5 werden hierdurch wirkungsvoll vermieden. Um hierzu gute Ergebnisse zu erreichen, ist erfindungsgemäss ein Beschusswinkelbereich +/-α zu durchlaufen, der die Werte im Bereich +/- 4° bis +/- 45° durchläuft. Besonders gute Ergebnisse werden erreicht für den Beschusswinkelbereich +/-α im Wertebereich +/- 4° bis +/- 20°.
Bei der wechselseitigen Bearbeitung ist darauf zu achten, dass jede Seite der Probe mindestens zwei mal mit dem Jonenstrahl bearbeitet wird. Besonders von Vorteil ist allerdings, wenn jede Seite der Probe mehrere male bearbeitet wird. Die Zeitdauer der Strahleinwirkung pro Bearbeitungsschritt hängt von der Ausgangsdicke und der Menge des ab zu dünnenden Materiales ab. Bei den bekannten FIB-Proben und den gewünschten Ergebnissen wird vorteilhafterweise in einem Bereich von einigen Sekunden bis einigen Minuten pro Seite und Schritt gearbeitet.
Vom gestörten Strukturbereich der FIB-Proben-Oberfläche 6a,b soll erfindungsgemäss möglichst viel abgetragen werden. Die maximal verbleibende Störtiefe der beiden Oberflächen 6a,b soll nach der Bearbeitung maximal 10 nm aufweisen, wobei gemäss erfindungsgemässem Vorgehen vorzugsweise maximal 5 nm gestörtes Material an den Oberflächen 6a,b übrig bleiben soll.

Solche hochauflösende Proben für den HRTEM-Einsatz, die weniger als 40 nm dick sind oder gar vorzugsweise weniger als 20 nm dick, sind besonders für Probenmaterialien im Bereich von Halbleiteruntersuchungen insbesondere für Halbleiter, die Materialien enthalten wie Si, GaAs, Ge geeignet.

Die Nachbehandlung kann erfindungsgemäss auch besonders gut automatisiert werden durch Einsatz von entpsrechenden programmierbaren Steuerungen. Hierbei kann sowohl der Zeittakt, die Anzahl der Ätzschritte und der Beschusswinkel, wie auch der Bewegungsverlauf wunschgemäss voreingestellt beziehungsweise programmiert werden und automatisch abgewickelt werden. Der gesamte Präparationsvorgang kann somit mit Hilfe eines Präparationsprogrammes entsprechend automatisiert werden und individuell auf die zu erstellenden Proben 5 angepasst werden. Die automatische Nachbehandlung von Proben 5 verlangt somit nicht die ständige Anwesenheit des Bedieners und ist dadurch zeitsparend, reproduzierbar und wirtschaftlich realisierbar.

Zur weiteren Verdeutlichung wird die erfindungsgemässe Nachbearbeitung einer FIB-Probe anhand eines Beispieles beschrieben. Als Ausgangsmaterial wird ein FIB-Schhitt beziehungsweise Lamelle 5 aus Silizium-Material mit einer Platin-Schutzschicht 13 verwendet. Die Lamelle ist 6 µm tief inklusive der Platin-Schutzschicht 13 und 13 µm breit. Für die erfindungsgemässe Nachdünnung wurde eine Ionen-Dünnung verwendet in einer Anlage RES 100 der Baltec AG, FL-9496 Balzers, Liechtenstein, welche für diese Anwendung besonders geeignet ist. Es wurde ein Ätzprogramm verwendet, welches einen automatischen Wechsel der Beschussrichtung der Ionenquelle ermöglichte. Der Probenhalter wurde jeweils nach einer Minute von der Position +α = 15° zu der Position -α = -15° gewechselt. Die Beschleunigungsspannung der Ionenquelle 7 betrug 2 keV und der Ionenstrom 1,3 mA. Neben dem wechselnden Beschusswinkel +/- α von maximal +/- 15° bezüglich der Lamellenoberfläche wurde die Probe um +/- 20° oszilliert, also gegenüber der Jonenstrahleinfallsrichtung hin und her vekippt im Takt von etwa o,1 Hz, um Vorzugsrichtung des Ätzstrahles an der Probe zu vermeiden. Die Musterprobe wurde zuerst insgesamt acht Minuten lang geätzt, dann betrachtet und dann mit zehn Minuten weitergeätzt und ebenfalls betrachtet und zuletzt nochmals mit drei Minuten weitergeätzt, also insgesamt 21 Minuten lang geätzt. Im Ergebnis konnten Proben erreicht werden, die bereits nach dem ersten Schritt dünner als 40 nm waren und nach den weiteren Schritten bereits im Bereich von 20 nm und darunter ohne wesentliche Kontamination der Oberflächen. In der Folge konnten entsprechend dem erfindungsgemässen Vorgehen hochauflösende und detailgetreue TEM-Bilder erzielt werden.

## Patentansprüche

1. TEM-FIB-Probe aus einem Festkörpermaterial, welche mit einem Nachbehandlungsschritt an deren Oberflächen (6a,b) auf eine gewünschte Dicke eingestellt ist, **dadurch gekennzeichnet, dass** die Dicke < 40 nm beträgt.

2. Probe nach Anspruch 1 **dadurch gekennzeichnet, dass** die Dicke < 20 nm beträgt.

3. Probe nach einem der Ansprüche 1 oder 2 **dadurch gekennzeichnet, dass** die Probe (5) an deren Oberflächen (6a,b) im wesentlichen keine Kontamination aufweist.

4. Probe nach einem der vorhergehenden Ansprüche **dadurch gekennzeichnet, dass** die Probe (5) hauptsächlich aus der ungestörten ursprünglichen Materialstruktur besteht.

5. Probe nach Anspruch 4 **dadurch gekennzeichnet, dass** der Anteil der gestörten Struktur beidseits der Probenoberflächen (6a,b) eine Störtiefe von max. 10 nm aufweist, vorzugsweise von max. 5 nm.

6. Probe nach einem der vorhergehenden Ansprüche **dadurch gekennzeichnet, dass** die Probe (5) aus Halbleitermaterial besteht.

7. Verfahren zur Herstellung einer TEM-FIB-Probe aus einem Festkörpermaterial **dadurch gekennzeichnet, dass** die Probe (5) durch einen Nachbearbeitungsschritt beidseits auf die gewünschte Dicke mit einem Ionenstrahl (8) wechselseitig nachgeätzt wird, wobei der Ionenstrahl (8) unter einem Beschusswinkel (α)relativ, abwechselnd auf die eine Seite (6a) und auf die andere Seite (6b) der Probe (5) geführt wird.

8. Verfahren nach Anspruch 7 **dadurch gekennzeichnet, dass** die Probe (5) und / oder der Ionenstrahl (8) relativ gegenüber der Probe (5) in Bezug auf die Probenanordnungsebene (9) um den Winkel +/-α gependelt wird.

9. Verfahren nach Anspruch 8 **dadurch gekennzeichnet, dass** das Pendeln mit kontinuierlicher Bewegung erfolgt.

10. Verfahren nach einem der Ansprüche 7 bis 9 **dadurch gekennzeichnet, dass** der Beschusswinkel (α) auf Werte im Bereich +/- 4° bis +/- 45°, vorzugsweise +/- 4° bis +/-20°, eingestellt wird.

11. Verfahren nach einem der Ansprüche 7 bis 9 **dadurch gekennzeichnet, dass** der strukturgestörte Oberflächenbereich (6a,b) der FIB-Probe (5) derart abgetragen wird, dass die verbleibende Probe (5) hauptsächlich aus dem ursprünglichen ungestörten Material besteht.

12. Verfahren nach Anspruch 11 **dadurch gekennzeichnet, dass** die verbleibende Reststörtiefe max. 10 nm ist, vorzugsweise max. 5 nm.

13. Verfahren nach Anspruch 12 **dadurch gekennzeichnet, dass** die nachbehandelte Probe (5) eine Dicke < 40 nm aufweist, vorzugsweise < 20 nm.

14. Verfahren nach einem der Ansprüche 7 bis 13 **dadurch gekennzeichnet, dass** die Nachbehandlung derart erfolgt, dass die Probenoberfläche (6a,b) im wesentlichen keine Kontamination aufweisen.

15. Verfahren nach einem der Ansprüche 7 bis 14 **dadurch gekennzeichnet, dass** der Ionenstrahl (8) mit einer Energie von 200 eV bis 10 keV betrieben wird und vorzugsweise nicht über der Probe (5) gescannt wird.

16. Verfahren nach einem der Ansprüche 7 bis 15 **dadurch gekennzeichnet, dass** die Probe (5) ein Halbleitermaterial ist.

17. Verfahren nach einem der Ansprüche 7 bis 16 **dadurch gekennzeichnet, dass** die wechselseitige Nachbearbeitung der Probe (5) mit einer Prozessteuerung automatisiert wird.
